# EUROPEAN PATENT APPLICATION

(11) **EP 0 672 911 A1**
(43) Date of publication of application: **20.09.1995**
(21) Application number: 94200480.5
(22) Date of filing: 25.02.1994
(51) Int. Cl.: G01R 31/316

(54) **Quiescent supply current test device**

(71) Applicant: ALCATEL BELL Naamloze Vennootschap, B-2018 Antwerpen 1 (BE); ALCATEL N.V., NL-2288 BH Rijswijk (NL)
(72) Inventor: Swerts, Urbain, B-2640 Mortsel (BE); Van Sas, Josephus, B-2382 Ravels (Poppel) (BE); Manhaeve, Hans Adriaan Raphael, B-8200 Sint-Michiels/Brugge (BE)

(57) **Abstract**

An I_{DDQ} current test device (TD) is proposed which allows to use high test vector frequencies by connecting the voltage supply terminal (V_{DD}) of the CMOS device under test (DUT) to a voltage supply terminal (B) of a measurement unit (MM). The voltage at the latter terminal is stabilized by the operation of a stabilized voltage source (MA1, MSR, MFR) in such a way that the current drawn from this source, i.e. the I_{DDQ} current, is measured as the voltage drop over a sensing resistor (MSR) included in this source.

In order to be able to accurately measure thus I_{DDQ} current whilst keeping a large measurement range, an overcurrent unit (OM), having a structure identical to that of the measurement unit but with a smaller resistance value for its sensing resistor (OSR), is used that first roughly determines whether the latter current is small enough to be accurately measured by the measurement unit. Furthermore, a power supply unit (PSU) supplies the high currents needed in the switching periods of the CMOS device.

## Description

The present invention relates to a test device for a CMOS device and including a current measurement circuit for testing said CMOS device by measuring a quiescent supply current flowing therein.

Such a test device is already known in the art, for instance from the article "A general purpose I_{DDQ} measurement circuit", by Wallquist et al., 1993 IEEE International Test Conference, paper 31.3, pp. 642-651. Therein, a test device is described which measures the quiescent power supply current, commonly referred to by the symbol I_{DDQ,} of the CMOS device according to the so called Keating-Meyer measurement principle.

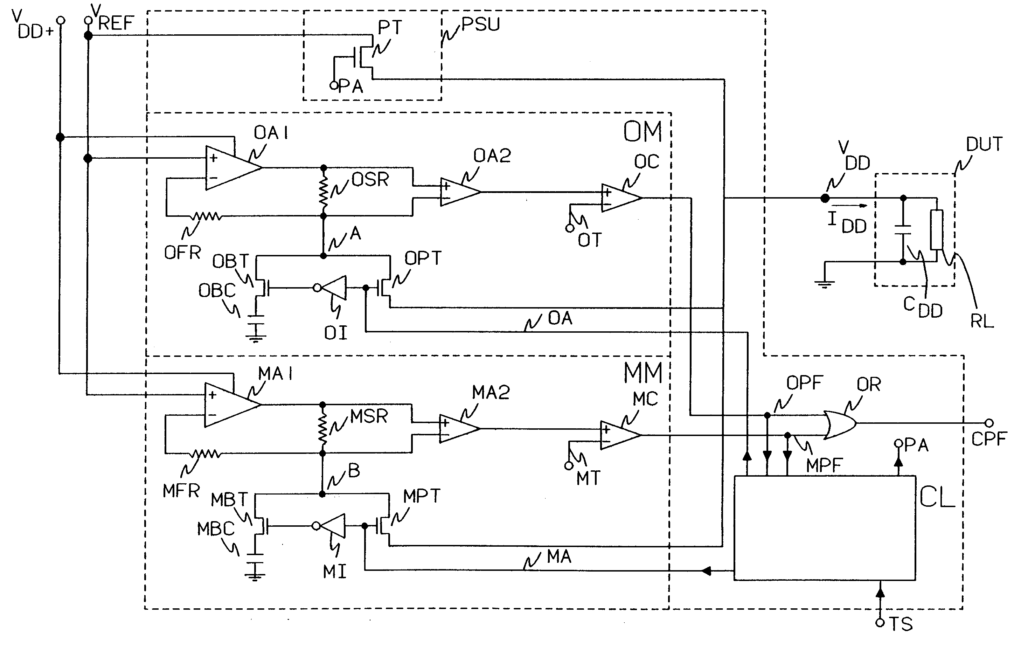

As shown in Fig. 1 of this article, this principle consists in opening a switch inbetween two switching periods, i.e. periods wherein the CMOS device is forced to switch to another state due to input level transitions to which it is subjected, such that the voltage supply terminal of the CMOS device is floated. In this way, the voltage at this terminal leaks away because of the I_{DDQ} current which discharges the capacitance, called node capacitance, of the CMOS device. It is clear that the resulting voltage drop at this terminal is indicative of the magnitude of the I_{DDQ} current and that this current may hence be measured and the CMOS device tested by measuring this voltage drop.

Application of the above Keating-Meyer principle is disadvantageous for the following three reasons.

Firstly and most importantly, the measurement speed which may be obtained with the known circuit is very limited. Indeed, since the I_{DDQ} current is inherently very small, it is necessary to monitor the above voltage drop for a relatively long time as it takes a long time for the node capacitance to be discharged to an extent which allows to accurately measure whether or not the I_{DDQ} current falls within an allowed range. Hence, the maximum vector frequency, i.e. the frequency with which the device may be tested for distinct input vectors, is limited especially for high capacitances at the above voltage supply terminal as can be also seen from Fig. 10 of the above mentioned article. Since normally a same CMOS device needs to be tested for thousands of such input vectors this limitation clearly constitutes a serious bar to an efficient use of such I_{DDQ} test devices.

Secondly, the voltage applied to the voltage supply terminal of the CMOS device may drop considerably when this CMOS device is malfunctioning. This may result in a change of state of the CMOS device during the measurement period, such change being unwanted since the test vector sequence to which the CMOS device is subjected is sequential in nature meaning that for accurate measurements the CMOS device should for any test vector be in a state that results from the application of the previous sequence of test vectors. More importantly however, the CMOS device may go into latch-up when its supply voltage drops too much below the voltage levels applied to its inputs such that the measurement process needs to be interrupted. It is to be noted that completion of the test sequence is needed even for malfunctioning CMOS devices when the test is used as a diagnostic test and hence when it is necessary to pinpoint as accurately as possible the extent and location of faults.

A final drawback of the above known device is that it requires the magnitude of the above node capacitance to be measured, this necessity making the device complex and hard to calibrate.

An object of the present invention therefore is to provide a test device of the above type but which allows the measurement of the I_{DDQ} current with high vector frequencies, which is independent of the node capacitance and in which the correct application of the test sequence is assured even for malfunctioning CMOS devices.

This object is achieved by virtue of the fact that said test device has at least one unit including a said measuring circuit and a stabilized voltage source adapted to supply said quiescent supply current to said CMOS device from a stabilized voltage supply terminal and that said current measurement circuit is coupled to said source and is adapted to measure said quiescent supply current by measuring the current supplied by said source.

In this way the above vector frequency is first of all neither limited by the magnitude of the I_{DDQ} current to be measured nor by the magnitude of the capacitance value at the voltage supply terminal. Indeed, the measurement speed of the test device is only limited by the speed with which a stable I_{DDQ} current is available at the measurement circuit. The latter speed may be very high since, through the operation of a stabilized voltage source, relatively high currents are available so as to cancel eventual transients such that the stable supply voltage required for accurate measurements is established in a rapid way.

Furthermore, through the use of the above mentioned stabilized voltage source neither latch-up nor CMOS state transitions can occur during the measurement period as the supply voltage to the CMOS device is fixed at a sufficient level with respect to the input voltages.

A characteristic feature of the present invention is that said stabilized voltage source includes an operational amplifier fed from a supply voltage higher than a reference voltage and having a positive input to which said reference voltage is applied and an output coupled back to its negative input via a current sensing feedback resistor itself coupled between said output and said stabilized voltage supply terminal, said measurement circuit being coupled to said current sensing resistor and being adapted to measure said quiescent supply current as a voltage drop over said current sensing resistor.

In this way a very simple stabilized voltage source is used which is very adequate for the present test device as the operational amplifier may be chosen so as to be able to supply high transient currents which improve the measurement speed and so as to absorb a significant voltage drop over the current sensing resistor. The latter in particular allows to accurately measure the I_{DDQ} current without this voltage drop influencing the supply voltage.

It is to be noted that straightforward application of current sensing (or viewing) resistors such as mentioned for instance in the above article, is impractical as without the above use of a stabilized voltage source these resistors would give rise to significant changes in the supply voltage corresponding to significant voltage drops over these sensing resistors required for accurate measurements. Such changes in supply voltage cause transients slowing down the measurement speed as well as inaccuracies in the measured I_{DDQ} current as is also noted in the above mentioned article. It is therefore apparent that the invention may also be appreciated as giving a solution for the above problems with sensing resistors such that this technique may still be used in the present field.

With a stabilized voltage source of the above type it clearly emerges that a maximum allowable voltage drop over the current sensing resistor may be computed above which the stabilized voltage source ceases to operate properly because of saturation or unlinearities. If now the possible range for the I_{DDQ} current is rather large, it might be the case that a single unit does not suffice to both accomodate currents at the high end of this range and to measure these currents with a given accuracy.

As can be verified, these problems are solved with the following features of the present invention, namely that said current measurement circuit includes a comparator comparing said voltage drop with a predetermined threshold voltage and generating an output signal with a condition that is indicative of the condition of said CMOS device, and that said test device includes a plurality of said units each coupled to said stabilized voltage supply terminal and each characterized by a maximum allowable said voltage drop, and that said units are arranged in a sequence according to increasing current sensing resistance values such that said threshold voltage in said units is reached for a current giving rise to said maximum voltage drop in a next unit of said sequence, and in that said test device further includes a control logic for activating, inbetween switching periods of said CMOS device, said units in sequence either until a said output signal is indicative of a malfunctioning condition or said sequence is completed and none of said output signals are indicative of a malfunctioning condition of said CMOS device.

In this way the I_{DDQ} current is first scanned over a plurality of ranges corresponding to a specific resistance value for the current sensing resistor and only passed to a following, more sensitive unit, if it is assured that the current falls within the operation range of this unit. The above allows to design a last unit giving a very accurate measurement range for making a final pass decision. Again, it is obtained in this way that application of a current sensing technique is made more feasible since the inevitable voltage drops are better controlled so that both accuracy and dynamic range may be combined.

It is to be noted that switching operations needed in order to run through the above sequence only have minimal effect on the measurement speed thanks to the above mentioned capacity of the stabilized voltage source to speedily cancel out transients.

Yet a further feature of the present invention is that said test device further includes a power supply unit coupled to said stabilized voltage supply terminal and activated during said switching periods by said control logic to supply power to said CMOS device.

By allowing the control logic also to switch to a conventional power supply during the switching periods of the CMOS device, the feasibility of the above approach is again enhanced. Indeed, during these switching periods currents of several orders of magnitude greater than normal I_{DDQ} currents may arise which are relatively hard to furnish with a voltage source of the above type but which pose no problem whatsoever for conventional power supplies.

Again, it is to be noted that measurement speed is not affected by this additional switching requirement because of the properties of the used stabilized voltage sources.

The above mentioned and other objects and features of the invention will become more apparent and the invention itself will be best understood by referring to the following description of an embodiment taken in conjunction with the accompanying drawing which shows a test device TD according to the present invention.

The test device TD is for instance implemented on a separate off-chip quiescent power supply test board or I_{DDQ} current test board together with other circuits (not shown) such as an I_{DDQ} test vector generator and result analyzer, a DC voltage (V_{DD+}) supply source with a positive pole V_{DD+} and a grounded negative pole and a reference voltage (V_{REF}) supply source with a positive pole V_{REF} and a grounded negative pole, the voltage V_{DD+} being larger than the voltage V_{REF}. TD is used to generate for each test vector applied to a CMOS device DUT a composite pass/fail output signal CPF indicating whether or not a measured quiescent current I_{DDQ} flowing in DUT is smaller than an allowable maximum current for this test vector. The output signal CPF is used as an input to the above generator and result analyzer which is able to apply typically thousands of distinct test vectors to inputs (not shown) of DUT with the purpose of checking whether and, if so, why this CMOS device DUT is malfunctioning. DUT is schematically represented as a so called node capacitance C_{DD} coupled in parallel with a resistive load RL between a voltage supply terminal V_{DD} and ground.

The test device TD includes three units PSU, OM and MM whose outputs are all coupled to a voltage supply terminal V_{DD} of DUT, as well as a control logic CL controlling - as is described lateron - these three units such as to alternately supply power to DUT.

PSU is a power supply unit comprising a power MOS transistor PT whose source-to-drain path is coupled between V_{REF} and V_{DD} and the gate of which is controlled by a control signal PA generated on a like named terminal by the control logic CL.

OM is an overcurrent unit including a stabilized voltage source OA1/OFR/OSR, a current measurement circuit OSR/OA2/OC and a switching circuit OBT/OBC/OI/OPT.

The stabilized voltage source OA1/OFR/OSR includes an operational amplifier OA1 fed from V_{DD+} and having V_{REF} applied to its positive input. Its output is coupled to its negative input through a feedback bias resistor OFR in series with a current sensing feedback resistor OSR and the junction point A of OSR and OFR constitutes an input terminal A of the switching circuit.

This switching circuit has two parallel branches, a first one of which includes a MOS transistor switch OPT coupled between input terminal A and V_{DD} and a second one comprising the series connection of a MOS transistor switch OBT and an anti-spike capacitor OBC coupled between the input terminal A and ground. A control signal OA generated on a like named terminal of the control logic CL is applied to the gate of OPT directly and via an invertor OI to the gate of OBT. OBT, OI and OPT thus constitute a change-over switching circuit able to connect input terminal A either to V_{DD} or to ground via capacitor OBC.

The measurement circuit includes sensing amplifier OA2 whose inputs are coupled across the terminals of the current sensing resistor OSR to sense the voltage drop that appears thereacross. The thus sensed voltage drop appears at the output terminal of OA2 which is connected to the positive input of a comparator OC which also forms part of the present measurement circuit. This comparator OC compares this sensed voltage drop with a threshold voltage OT which is applied to its negative input OT and produces an overcurrent pass/fail output signal OPF which is applied to an input of the control logic CL as well as to an OR gate OR providing the composite pass/fail signal output signal CPF which is indicative of the condition of DUT.

MM is a measurement unit MM which has a structure identical to that of the overcurrent unit OM and particularly includes a stabilized voltage source MA1/MFR/MSR, a switching circuit MBT/MBC/MI/MPT and a current measurement circuit MSR/MA2/MC. Therefore it is not described in detail and it suffices to say that it is controlled by a control signal MA appearing on a like named terminal of the control logic CL, that a measurement pass/fail output signal MPF is applied via a like named terminal to the control logic CL as well as to an input of the above gate OR and that the switching circuit has an input terminal B.

Finally, it is to be noted that the control logic CL is not shown in detail since it may without difficulty be designed by a person skilled in the art from the description of its operation given lateron. This description specifies in particular the relation between the inputs and the outputs PA, OA, MA of this control logic CL. These inputs comprise, apart from the above mentioned pass/fail output signals MPF and OPF, a trigger signal TS generated by the test vector generator (not shown) and indicating the switching periods wherein the latter generator forces the CMOS device DUT to switch to another state.

With reference to the above structure of the test device TD, its operation may now be described in detail.

In response to the trigger signal TS indicating that DUT switches to another state and thus defining the start of a switching period, CL activates the control signal PA as a consequence of which the power transistor PT becomes conductive. It thereby supplies a high supply current I_{DD} (typically 10A) required during such a switching period to the voltage supply terminal V_{DD} of DUT and which high current may not be supplied by the units OM and MM. Meanwhile, CL deactivates the other control signals OA and MA such that the transistor switches OPT and MPT in the overcurrent unit OM and the measurement unit MM are both deactivated. On the contrary, the transistor switches OBT and MBT are conductive so that the input terminals A and B are connected to ground via capacitors OBC and MBC respectively.

The stabilized voltage sources of OM and MM can thus maintain the input terminals A and B both at the reference voltage V_{REF} by either charging or discharging the capcitors OBC and MBC. The latter capacitors OBC and MBC thus avoid that large spikes and transients occur when the change over swiches are controlled via the signals OA and MA to change their state and thus enhance the measurement speed of the test device TD.

When the trigger signal TS changes its state at the end of a switching period, a measurement period starts during which the quiescent supply current I_{DDQ} is measured. At the start of the latter period, the control logic CL on the one hand disables PSU by deactivating its control signal PA and on the other hand enables the overcurrent unit OM by activating its control signal OA. Meanwhile, the control logic CL maintains the measurement unit MM in a condition wherein MPT is blocked CL at least at the start of a measurement period for the reasons given hereafter.

The stabilized voltage sources incorporated in both the overcurrent and measurement units OM and MM may only be coupled to DUT via OPT or MPT to supply a current I_{DD} which is small enough to ensure that the voltage drop over the sensing resistor OSR or MSR does not exceed a maximum allowable value. When using, for instance, operational amplifiers OA1 and MA1 of the type generally available on the market under reference AD829 (manufactured by Analog Devices) and chosen for their capability to supply very high currents during transients, this maximum voltage drop is equal to approximately 1V. The latter maximum voltage drop is so chosen that these operational amplifiers are kept within their linear region and that the sensing amplifiers OA2 and MA2 constituting a following amplification stage are not overdriven.

For this reason and with a specific range for the I_{DDQ} current of for instance 1µA to 10mA, a current sensing resistance value has to be chosen which may not be larger than 100Ω. However, this is not sufficient to perform the measurements with a required accuracy of for instance 1µA.

The latter problem may be solved by using the two above units OM and MM in sequence; the overcurrent unit OM having a current sensing resistor OSR of 100 Ω is used first since it allows to determine with sufficient accuracy whether or not the I_{DDQ} current is smaller than 1 mA and the measurement unit MM having a current sensing resistor of 1KΩ is used thereafter since it allows, once it has been established that the I_{DDQ} current is smaller than 1 mA, to measure the latter current with the mentioned required accuracy of 1µA in the range of 1µA to 1mA.

More particularly, at the start of a measurement period, CL first enables the overcurrent unit OM in order to check whether or not the measured current falls within the allowed measurement range of the measurement unit MM. This is done by comparator OC which compares the sensed voltage drop over OSR with a threshold voltage OT having a value that corresponds to a voltage drop of 0.1 mV over OSR. The comparator OC so generates a pass/fail output signal OPF which is activated when the measured I_{DDQ} current is higher than 1mA and thus falls outside the allowed range for MM.

In receiving such an activated signal OPF, CL does not enable MM by activating the control signal MA but instead disables OM and again enables the power supply unit PSU by deactivating and activating the corresponding control signals OA and PA. On the other hand, the activated output signal OPF also activates via the gate OR the composite pass/fail output signal such that the mentioned analyzer (not shown) is notified that the present I_{DDQ} current indicates that the DUT is malfunctioning.

In the other case, i.e. when the signal OPF remains deactivated thereby indicating that the I_{DDQ} current is smaller than 1mA, the control logic CL continues the measurement operation by disabling OM through deactivating the control signal OA and by enabling MM through activating the control signal MA. Via comparator MC, the measurement unit MM then checks with the required accuracy whether or not the I_{DDQ} current is small enough by comparing the sensed voltage drop with a threshold voltage MT having a value corresponding to a voltage drop over MSR between 0.1V and 1V. If this is not the case MC activates the pass/fail output signal MPF, i.e. when this current is too high, and in response thereto CL ends the measurement period by disabling MM and enabling PSU instead whilst through the gate OR the composite pass/fail output signal CPF is activated thereby again indicating that DUT is malfunctioning for the presently applied test vector.

It is to be noted that when none of the above two pass/fail output signals OPF and MPF are activated during the measurement period, the control logic CL also disables MM and enables PSU instead upon occurrence of a level transition of the trigger signal TS. In this case the above analyzer knows from the fact that CPF remained deactivated during the whole measurement period, i.e. prior to the above level transition on TS, that the DUT is OK for the present test vector.

While the principles of the invention have been described above in connection with specific apparatus, it is to be clearly understood that this description is made only by way of example and not as a limitation on the scope of the invention.

## Claims

1. Test device (TD) for a CMOS device (DUT) and including a current measurement circuit (MA2, MC) for testing said CMOS device by measuring a quiescent supply current (I_{DD}) flowing therein, characterized in that said test device (TD) has at least one unit including a said measuring circuit (MA2, MC) and a stabilized voltage source (MA1, MSR, MFR) adapted to supply said quiescent supply current (I_{DD}) to said CMOS device (DUT) from a stabilized voltage supply terminal (V_{DD}) and that said current measurement circuit is coupled to said source and is adapted to measure said quiescent supply current by measuring the current supplied by said source.

2. Test device (TD) according to claim 1, characterized in that said stabilized voltage source (MA1, MSR, MFR) includes an operational amplifier (MA1) fed from a supply voltage (V_{DD+}) higher than a reference voltage (V_{REF}) and having a positive input to which said reference voltage (V_{REF}) is applied and an output coupled back to its negative input via a current sensing feedback resistor (MSR) itself coupled between said output and said stabilized voltage supply terminal (V_{DD}), said measurement circuit (MA2, MC) being coupled to said current sensing resistor and being adapted to measure said quiescent supply current (I_{DD}) as a voltage drop over said current sensing resistor.

3. Test device (TD) according to claim 2, characterized in that said current measurement circuit (MA2, MC) includes a comparator (MC) comparing said voltage drop with a predetermined threshold voltage (MT) and generating an output signal (MPF) with a condition that is indicative of the condition of said CMOS device (DUT).

4. Test device according to claim 3, characterized in that said test device (TD) includes a plurality of said units (OM/MM) each coupled to said stabilized voltage supply terminal (V_{DD}) and each characterized by a maximum allowable said voltage drop (1V), and that said units are arranged in a sequence according to increasing current sensing resistance values such that said threshold voltage (OT/MT) in said units is reached for a current giving rise to said maximum voltage drop in a next unit of said sequence, and in that said test device further includes a control logic (CL) for activating, inbetween switching periods of said CMOS device, said units in sequence either until a said output signal (OPF/MPF) is indicative of a malfunctioning condition or said sequence is completed and none of said output signals are indicative of a malfunctioning condition of said CMOS device.

5. Test device (TD) according to claim 4, characterized in that said threshold voltage (MT) in a last said unit (MM) of said sequence is reached for a maximum allowable said quiescent supply current (I_{DD}).

6. Test device (TD) according to claim 4, characterized in that said test device (TD) further includes a power supply unit (PSU) coupled to said stabilized voltage supply terminal (V_{DD}) and activated during said switching periods by said control logic (CL) to supply power to said CMOS device (DUT).

7. Test device (TD) according to claim 5, characterized in that said power supply unit (PSU) is a power transistor (PT) coupled between a terminal (V_{REF}) at which said reference voltage is applied and said stabilized voltage supply terminal (V_{DD}) and whose control input (PA) is coupled to a control output of said control logic (Cl).
